**Europäisches Patentamt**

**European Patent Office**

**Office européen des brevets**

(19)

(11) Veröffentlichungsnummer: **0 518 068 A1**

# (12) EUROPÄISCHE PATENTANMELDUNG

(21) Anmeldenummer: **92108031.3**

(22) Anmeldetag: **13.05.92**

(51) Int. Cl.5: **G01R 31/02**, G01R 31/28

(30) Priorität: **10.06.91 DE 4119109**

(43) Veröffentlichungstag der Anmeldung:
**16.12.92 Patentblatt 92/51**

(84) Benannte Vertragsstaaten:
**AT BE CH DE FR GB IT LI**

(71) Anmelder: **GRUNDIG E.M.V.**
**Elektro-Mechanische Versuchsanstalt Max Grundig holländ. Stiftung & Co. KG.**
**Kurgartenstrasse 37**
**W-8510 Fürth/Bay.(DE)**

(72) Erfinder: **Schätz, Hans, Grundig E.M.V.**
**holländ. Stiftung & Co KG, Kurgartenstrasse 37**
**W-8510 Fürth/Bay(DE)**

(74) Vertreter: **Eichstädt, Alfred**
**Grundig E.M.V. Elektro-Mechanische Versuchsanstalt Kurgartenstrasse 37**
**W-8510 Fürth(DE)**

(54) **Verfahren zum Testen von Displaybausteinen und Anordnung zur Durchführung des Verfahrens.**

(57) Die Erfindung betrifft ein Verfahren zum Testen von Displaybausteinen und eine Anordnung zur Durchführung des Verfahrens. Bei diesem Testverfahren werden die einzelnen Segmente des zu testenden Displaybausteins unter Einbeziehung einer Prüfung auf Kurzschlüsse in den Ansteuerleitungen geprüft.

Bei bekannten Anordnungen werden die einzelnen Ansteuerleitungen separat auf Kurzschlüsse und die Displaysegmente auf Funktionsfähigkeit geprüft. Ziel der Erfindung ist es die Anzahl der benötigten Prüfschritte zu verringern.

Dies wird erreicht, indem die Prüfung in k Schritten erfolgt und im k-ten Schritt jeweils $2^{k-1}$ Ansteuerleitungen zu einer Gruppe zusammengefaßt werden. Diese Leitungsgruppen werden abwechselnd mit einer logischen 0 und einer logischen 1 angesteuert. Bei jedem Prüfschritt erfolgt eine Auswertung, indem die Anzahl und Position der aufleuchtenden Displaysegmente mit einem vorgegebenen Muster verglichen werden. Wenn kein Fehler erkannt wird, wird zum nächsten Prüfschritt übergegangen.

Figur 1

EP 0 518 068 A1

Die Erfindung betrifft ein Verfahren zum Testen von Displaybausteinen und eine Anordnung zur Durchführung des Verfahrens. Bei diesem Testverfahren werden die einzelnen Segmente des zu testenden Displaybausteins unter Einbeziehung einer Prüfung auf Kurzschlüsse in den Ansteuerleitungen geprüft.

Displaybausteine werden in vielen Anwendungen als Anzeigeelemente für die Darstellung von Meßergebnissen, Bedienungshinweisen oder Einstellparametern in den verschiedensten Geräten eingesetzt. Die Entwicklung zu immer größeren Displays mit mehr ansteuerbaren und darstellbaren Anzeigesegmenten erfordert automatische Prüfanlagen, die die fehlerfreie Funktion der einzelnen Displaysegmente sowie deren Ansteuerleitungen überprüfen.

Eine Anordnung zum Testen von lichtemittierenden Bausteinen und Displays ist aus der europäischen Offenlegungsschrift EP 0285493 A2 bekannt. In dieser Druckschrift wird eine Testanordnung beschrieben, die in Verbindung mit konventionellen automatischen Testvorrichtungen für die Prüfung von lichtemittierenden Anordnungen eingesetzt werden kann. Diese Anordnung enthält mehrere einzelne Lichtleiter, die nach einem bestimmten Muster angeordnet sind, wobei jeder Lichtleiter einer lichtemittierenden Komponente der zu prüfenden Anordnung zugeordnet ist. Über jeweils einen Lichtleiter ist eine Komponente mit einem Detektor verbunden, der das Lichtsignal in ein elektrisches Signal umwandelt, so daß es mit einer herkömmlichen automatischen Testvorrichtung ausgewertet werden kann.

Es sind weiterhin Testanordnungen bekannt, die mit einem automatischen Bildverarbeitungssystem arbeiten. Bei diesen Anordnungen wird eine Fernsehkamera auf das zu prüfende Display gerichtet. Zur Überprüfung auf Ansteuerleitungsunterbrechungen oder auf die Funktionsfähigkeit der Displaysegmente werden alle Segmente angesteuert und dann ein Bild davon aufgenommen. Im Bildverarbeitungssystem wird überprüft, ob alle Segmente leuchten. Zur Überprüfung auf Kurzschlüsse zwischen zwei Leitungen wird jeweils ein Segment des Displays angesteuert und dann ein Bild davon aufgenommen. Im Bildverarbeitungssystem wird überprüft, ob das entsprechende Segment aufleuchtet bzw. ob noch weitere, nicht angesteuerte, Segmente aufleuchten. Für den Fall, daß mehrere Segmente aufleuchten wird ein Kurzschluß zwischen den Ansteuerleitungen der aufleuchtenden Segmente erkannt. Wird kein Fehler erkannt, dann wird ein nächstes Displaysegment angesteuert, usw. Bereits bei einem relativ kleinen Display, wie es in Autoradios mit alphanumerischer Darstellung verwendet wird, sind beispielsweise 192 Segmente ansteuerbar, d.h. es müssen 192 Bilder aufgenommen und ausgewertet werden. Dies ist insbesondere deshalb notwendig, weil der Verflechtungsgrad der Leitungen untereinander nicht bekannt ist, so daß es nicht genügt, jeweils benachbarte Leitungen gegeneinander auf Kurzschluß zu prüfen. Es müssen also alle denkbaren Kombinationen geprüft werden. Eine solche Prüfung hat den Nachteil, daß sie sehr zeitaufwendig und damit auch teuer ist.

Es ist deshalb Aufgabe der Erfindung ein Verfahren und eine Anordnung zur Durchführung des Verfahrens zum automatischen Testen von Displaybausteinen anzugeben, bei dem die Anzahl der Prüfschritte, die für einen sicheren Test notwendig sind, verringert werden kann.

Diese Aufgabe wird gelöst, indem die Prüfung in k Schritten erfolgt und im k-ten Schritt jeweils $2^{k-1}$ Ansteuerleitungen zu einer Gruppe zusammengefaßt werden. Diese Leitungsgruppen werden abwechselnd mit einer logischen 0 und einer logischen 1 angesteuert. Bei jedem Prüfschritt erfolgt eine Auswertung, indem die Anzahl und die Positionen der aufleuchtenden Displaysegmente mit einem vorgegebenen Muster verglichen werden. Wenn kein Fehler erkannt wird, wird zum nächsten Prüfschritt übergegangen. Die Anzahl der notwendigen Prüfschritte ist abhängig von der Anzahl der Ansteuerleitungen und ergibt sich aus folgender Beziehung:

$$n \leq 2^k < 2n,$$

wobei n die Anzahl der Ansteuerleitungen und k die Anzahl der Prüfschritte angibt. Im folgenden wird das Verfahren an Hand eines Beispiels erläutert:

Ein Displaybaustein soll mit 8 Ansteuerleitungen angesteuert werden. Bei 8 Ansteuerleitungen ergeben sich m = $\frac{8}{2}$ = 28 Kurzschlußmöglichkeiten zwischen zwei Ansteuerleitungen. Explizit ausgedrückt ergeben sich Kurzschlußmöglichkeiten nach der folgender Tabelle 1:

```
1-2
1-3   2-3
1-4   2-4   3-4
1-5   2-5   3-5   4-5
1-6   2-6   3-6   4-6   5-6
1-7   2-7   3-7   4-7   5-7   6-7
1-8   2-8   3-8   4-8   5-8   6-8   7-8
```

Tabelle 1

Mit dem erfindungsgemäßen Verfahren werden zunächst paarweise benachbarte Anschlußleitungen auf Kurzschluß überprüft, indem je eine Leitung mit logisch 0 und eine Leitung mit logisch 1 angesteuert wird. Auf diese Weise werden benachbarte Leitungen mit verschiedenen Pegeln angesteuert und führen somit verschiedene Signale, solange kein Kurzschluß auftritt. Für die Überprüfung der Displaysegmente bedeutet dies, daß bestimmte Segmente an bzw. aus sein müssen. Die Überprüfung findet mit einer Aufnahmekamera und einer Bildverarbeitungseinheit statt oder mit einzelnen Lichtleitern, von denen jeder das Licht eines Displaysegmentes aufnimmt und an eine Auswerteeinheit weiterführt, in der die gewonnenen Daten verarbeitet werden. Wenn kein Kurzschluß vorhanden ist, stimmt das gewonnene Muster mit einem vorgegebenen Muster überein. Im nächsten Schritt werden nun jeweils zwei benachbarte Leitungen zu einer Gruppe zusammengefaßt und es werden die Leitungsgruppen abwechselnd mit logisch 0 und logisch 1 angesteuert. Danach findet wieder ein Vergleich mit einem vorgegebenen Muster statt. Wenn hier wieder kein Kurzschluß aufgetreten ist, werden jeweils zwei der Leitungsgruppen aus dem vorherigen Prüfschritt zu einer neuen Gruppe zusammengefaßt und die beiden entstandenen Leitungsgruppen werden mit unterschiedlichem Pegel angesteuert. Die Auswertung findet wieder analog zum vorherigen Prüfschritt statt.

Die Tabelle 2 zeigt die einzelnen Kombinationen der drei Prüfschritte.

| Leitung | Prüfschritt 1 | Prüfschritt 2 | Prüfschritt 3 |
|---------|---------------|---------------|---------------|
| 1 | 1 | 1 | 1 |
| 2 | O | 1 | 1 |
| 3 | 1 | O | 1 |
| 4 | O | O | 1 |
| 5 | 1 | 1 | O |
| 6 | O | 1 | O |
| 7 | 1 | O | O |
| 8 | O | O | O |

Tabelle 2

Tabelle 3 zeigt die erfassten Kurzschlußmöglichkeiten bei den Prüfschritten 1-3 entsprechend Tabelle 2:

| Prüfschritt 1 | Prüfschritt 2 | Prüfschritt 3 |
|---|---|---|
| + 1-2 | + 1-3 | + 1-5 |
| + 3-4 | + 1-4 | + 1-6 |
| + 5-6 | + 2-3 | + 1-7 |
| + 7-8 | + 2-4 | + 1-8 |
| 1-4 | + 5-7 | + 2-5 |
| 1-6 | + 5-8 | + 2-6 |
| 1-8 | + 6-7 | + 2-7 |
| 3-6 | + 6-8 | + 2-8 |
| 3-8 | 1-7 | + 3-5 |
| 3-2 | 1-8 | + 3-6 |
| 5-2 | 2-7 | + 3-7 |
| 5-4 | 2-8 | + 3-8 |
| 5-8 | 5-3 | + 4-5 |
| 7-6 | 5-4 | + 4-6 |
| 7-4 | 6-3 | + 4-7 |
| 7-2 | 6-4 | + 4-8 |

Tabelle 3

In der Tabelle 3 brauchen bei dem jeweiligen Prüfschritt nur die mit " + " gekennzeichneten Kurzschlußmöglichkeiten geprüft werden, die nicht gekennzeichneten sind redundant.

Bei 8 Ansteuerleitungen werden folglich durch 3 Prüfschritte alle Kurzschlußmöglichkeiten überprüft. Für einen Displaybaustein mit 196 ansteuerbaren Segmenten werden beispielsweise 28 Ansteuerleitungen benötigt, wenn die Ansteuerung mit einer Matrix von 16/12 Leitungen angesteuert wird. Bei 28 Ansteuerleitungen werden 5 Prüfschritte benötigt. Die Anzahl der benötigten Prüfschritte errechnet sich nach der folgenden Formel:

$$n \leq 2^k < 2n.$$

In dieser Formel bezeichnet n die Zahl der Ansteuerleitungen und k die Zahl der benötigten Prüfschritte. Die Anzahl der Prüfschritte verringert sich bei einem Display mit 196 ansteuerbaren Segmenten von 196 auf 5. Durch diese enorme Einsparung gegenüber der herkömmlichen Methode verkürzt sich die Prüfzeit für ein Display erheblich.

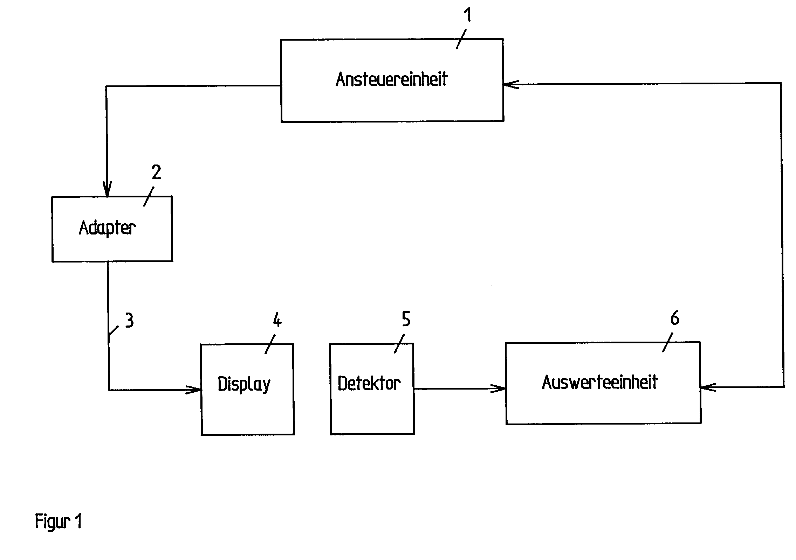

Im folgenden wird eine mögliche Anordnung zur Durchführung des Prüfverfahrens an Hand der Figur 1 beschrieben.

Diese Anordnung enthält eine Ansteuereinheit 1, die mit einem Adapter 2 verbunden ist. Der Adapter 2 ist über eine Verbindungsleitung 3 mit dem zu prüfenden Display 4 verbunden. Ein Detektor 5 tastet das Display 4 optisch ab und ist mit einer Auswerteeinheit 6 verbunden. Diese Auswerteeinheit 6 ist mit einer bidirektionalen Datenleitung mit der Ansteuereinheit 1 verbunden.

Die Ansteuereinheit 1 gibt die Ansteuersignale über den Adapter 2 entsprechend der Verfahrensvorschriften an das Display 4. Entsprechend dem Prüfschritt werden jeweils die zusammengefassten Leitungsgruppen mit den vorgegebenen Pegeln angesteuert. Auf dem Display leuchten im fehlerfreien Betrieb die angesteuerten Segmente auf. Der Detektor 5, der aus einer Aufnahmekamera oder aus den einzelnen Segmenten zugeordneten Lichtleitern und einer Wandlereinheit, der die Lichtsignale in elektrische Signale umwandelt, besteht, empfängt die Lichtsignale. Diese Lichtsignale werden in der Auswerteeinheit 6,

4

beispielsweise einer Bildverarbeitungseinheit, ausgewertet. In Abhängigkeit des Ergebnisses der Auswertung wird der Ansteuereinheit durch ein Zustandssignal angezeigt, daß der nächste Prüfschritt auszuführen ist. Die Ansteuereinheit 1 teilt der Auswerteeinheit mit, welcher Prüfschritt ausgeführt wird und gibt somit der Auswerteeinheit 6 an, mit welchem Testmuster das empfangene Muster verglichen werden muß.

Die Überprüfung auf defekte Displaysegmente ist in der Prüfung gemäß dem erfindungsgemäßen Verfahren enthalten, da ein defektes Segment, das nicht aufleuchtet, eine Abweichung des zu prüfenden Musters vom vorgegebenen Muster verursacht.

Mit dem erfindungsgemäßen Verfahren können auch unbestückte Leiterplatten auf Kurzschlüsse überprüft werden. In diesem Fall werden statt dem optischen Display 4 die Ausgangsanschlüsse der Leiterplatte überprüft, wobei der Detektor 5 der Anordnung nach Figur 1 ein einfacher Signaldetektor für elektrische Signale ist.

**Patentansprüche**

1. Verfahren zum Testen von Displaybausteinen und deren Ansteuerleitungen durch Überprüfen der einzelnen Segmente des zu testenden Displaybausteins und durch Prüfung auf Kurzschlüsse in den Ansteuerleitungen, wobei der Displaybaustein mit n Ansteuerleitungen angesteuert wird, **dadurch gekennzeichnet,** daß die Prüfung in k Schritten erfolgt, wobei $n \leq 2^k < 2n$ gilt, daß jeweils im k-ten Schritt $2^{k-1}$ Ansteuerleitungen zu einer Gruppe zusammengefaßt werden und die Leitungsgruppen jeweils abwechselnd mit logisch 0 und logisch 1 angesteuert werden, und daß bei jedem Prüfschritt eine Auswertung erfolgt, indem die Anzahl und Position der aufleuchtenden Displaysegmente mit einem vorgegebenen Muster verglichen wird.

2. Anordnung zur Durchführung des Verfahrens nach Anspruch 1, **dadurch gekennzeichnet,** daß sie eine Ansteuereinheit (1) enthält, die über einen Adapter (2) den optischen Displaybaustein (4) über die Ansteuerleitungen (3) ansteuert, daß die Anordnung einen optischen Detektor (5) enthält, mit dem die aufleuchtenden Displaysegmente optisch abgetastet werden, daß der optische Detektor (5) mit einer Auswerteeinheit (6) verbunden ist und diese Auswerteeinheit über eine bidirektionale Datenleitung mit der Ansteuereinheit (1) verbunden ist.

3. Anordnung nach Anspruch 2, **dadurch gekennzeichnet,** daß der optische Detektor (5) in Form einer Kamera und die Auswerteeinheit (6) in Form einer automatischen Bilverarbeitungseinheit ausgebildet sind.

4. Anordnung nach Anspruch 2, **dadurch gekennzeichnet,** daß der optische Detektor (5) aus Lichtleiterkabeln und Photodetektoren besteht, wobei jedem Displaysegment mindestens ein Lichtleiterkabel und jedem Lichtleiterkabel mindestens ein Photodetektor zugeordnet ist und die Signale des Photodetektors der Auswerteeinheit (6) zugeführt sind.

Figur 1

EP 0 518 068 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | PATENT ABSTRACTS OF JAPAN vol. 5, no. 191 (P-92)(863) 5. Dezember 1981 & JP-A-56 114 771 ( HITACHI ) 9. September 1981 * Zusammenfassung * --- | 1 | G01R31/02 G01R31/28 |
| D,Y | EP-A-0 285 493 (GENRAD) * Spalte 2, Zeile 47 - Zeile 59 * * Spalte 3, Zeile 27 - Spalte 4, Zeile 58 * * Spalte 5, Zeile 45 - Zeile 59; Abbildungen 1-3,5 * | 1 | |
| A | --- | 2-4 | |
| A | PATENT ABSTRACTS OF JAPAN vol. 7, no. 113 (P-197)(1258) 18. Mai 1983 & JP-A-58 033 170 ( NIPPON DENKI ) 26. Februar 1983 * Zusammenfassung * --- | 1 | |
| A | DE-A-3 205 975 (ECKARDT AG) * Seite 6, Absatz 2; Abbildungen 1,2; Tabelle 1 * ----- | 1 | RECHERCHIERTE SACHGEBIETE (Int. Cl.5 )  G01R |

Der vorliegende Recherchenbericht wurde für alle Patentansprüche erstellt

| Recherchenort | Abschlußdatum der Recherche | Prüfer |
|---|---|---|
| DEN HAAG | 09 SEPTEMBER 1992 | SINAPIUS G.H. |